# EUROPÄISCHE PATENTSCHRIFT

(11) **EP 1 592 074 B1**
(45) Veröffentlichungstag und Bekanntmachung des Hinweises auf die Patenterteilung: **27.06.2018**
(21) Anmeldenummer: 05007564.7
(22) Anmeldetag: 06.04.2005
(51) Int. Cl.: H01L 33/00, H01L 33/50, H01L 33/54, H01L 33/56

(54) **Leuchtdiodenanordnung und Verfahren zur dessen Herstellung**
Light emitting diode assembly and method of manufacturing thereof
Dispositif à diodes électroluminescentes et son procédé de fabrication

(30) Priorität: 30.04.2004 DE 102004021233
(43) Veröffentlichungstag der Anmeldung: 02.11.2005
(73) Patentinhaber: OSRAM Opto Semiconductors GmbH, 93055 Regensburg (DE)
(72) Erfinder: Guenther, Ewald Karl Michael, 93128 Regenstauf (DE); Waitl, Günter, 93049 Regensburg (DE); Brunner, Herbert, 93161 Sinzing (DE); Strauss, Jörg, 93051 Regensburg (DE)
(74) Vertreter: Epping - Hermann - Fischer

(56) Entgegenhaltungen:
- EP-A1- 1 119 058
- EP-A2- 1 178 544
- EP-A2- 1 548 851
- WO-A2-2005/043631
- GB-A- 2 373 368
- JP-A- H11 177 138
- JP-A- 2003 249 689
- JP-A- 2003 258 312

## Beschreibung

Die Erfindung betrifft eine Leuchtdiodenanordnung sowie ein Verfahren zur Herstellung einer Leuchtdiodenanordnung.
Die Druckschrift US 6,657,379 B2 betrifft eine Leuchtdiodenanordnung, die wenigstens eine Leuchtdiode aufweist, die Licht in einem Wellenlängenbereich von 300 bis 485 nm emittiert. Dabei wird das emittierte Licht durch Leuchtstoffe, die der primären Strahlung der Leuchtdiode ausgesetzt sind, teilweise oder vollständig in bevorzugt langreichweitigere Strahlung konvertiert. Der Leuchtdiodenchip ist dabei in die Ausnehmung eines Gehäuses angeordnet. Die Wände des Gehäuses sind reflektierend ausgebildet, und die Ausnehmung ist mit einer Vergussmasse gefüllt, welche den Leuchtdiodenchip vollständig umhüllt. Die Leuchtstoffpartikel zur Konvertierung des vom Leuchtdiodenchip abgegebenen Lichts sind dieser Vergussmasse beigemischt.
Die Druckschrift DE 100 204 65 A1 beschreibt ein strahlungsemittierendes Halbleiterbauelement mit einem Lumineszenzkonversionselement. Dabei ist ein Leuchtdiodenchip in eine Ausnehmung eines Grundkörpers angeordnet. Innerhalb der Ausnehmung des Gehäuses ist um den Halbleiterkörper ein napfartiger Bereich ausgeformt, der ein Lumineszenzkonversionselement enthält, das den Diodenchip einhüllt. Die inneren Seitenflächen des napfartigen Bereichs sind reflektierend ausgebildet. Der verbleibende Teil der Ausnehmung ist von einer transparenten Vergussmasse ausgefüllt.

Die Druckschriften EP 1 178 544 A2, EP 1 119 058 A1, WO2005/043631 A2, JP H11-177138A beschreiben Leuchtdiodenanordnungen.

Es ist Aufgabe der vorliegenden Erfindung, eine Leuchtdiodenanordnung anzugeben, die besonders kostengünstig hergestellt werden kann. Ferner ist es Aufgabe der Erfindung, ein Verfahren zur Herstellung solch einer Leuchtdiodenanordnung anzugeben.

Diese Aufgabe wird gelöst durch eine Leuchtdiodenanordnung nach Patentanspruch 1 und ferner durch ein Verfahren nach Patentanspruch 11. Vorteilhafte Ausgestaltungen der Erfindung sind Gegenstand von Unteransprüchen.

Die Erfindung betrifft eine Leuchtdiodenanordnung nach Anspruch 1 sowie ein Verfahren nach Anspruch 11.

Es wird eine Leuchtdiodenanordnung angegeben, die wenigstens einen Leuchtdiodenchip aufweist. Der Leuchtdiodenchip weist eine Strahlungsauskoppelfläche auf. Die Strahlungsauskoppelfläche wird beispielsweise durch eine der Oberflächen des Leuchtdiodenchips gebildet. Die im Leuchtdiodenchip erzeugte elektromagnetische Strahlung wird zu einem Großteil über diese Strahlungsauskoppelfläche ausgekoppelt.

Auf der Strahlungsauskoppelfläche ist wenigstens eine Leuchtstoffschicht angeordnet. Die Leuchtstoffschicht enthält bevorzugt eine Matrix, in die ein Lumineszenzkonversionsmaterial gemischt ist. Unter einem Lumineszenzkonversionsmaterial ist dabei ein Material zu verstehen, das Bestandteile aufweist, mittels derer die durch die Strahlungsauskoppelfläche ausgekoppelte elektromagnetische Strahlung in eine elektromagnetische Strahlung veränderter Wellenlänge konvertiert wird. Die Leuchtstoffschicht dient also zur Konvertierung der von dem Leuchtdiodenchip erzeugten elektromagnetischen Strahlung in elektromagnetische Strahlung einer anderen Wellenlänge. Besonders bevorzugt ist die Leuchtstoffschicht dabei zwischen 10 und 50 µm dick.

Weiter ist der Leuchtdiodenchip in ein Gehäuse eingebettet. Das heißt, der Leuchtdiodenchip ist von einem Gehäuse formschlüssig umhüllt, wobei die Oberfläche der Leuchtstoffschicht, die der Strahlungsauskoppelfläche des Leuchtdiodenchips gegenüberliegt, vom Gehäuse zumindest teilweise unbedeckt ist.
In einer bevorzugten Ausführungsform der Leuchtdiodenanordnung ist auf der Strahlungsauskoppelfläche seitlich eine erste Kontaktschicht aufgebracht. Das heißt, die Kontaktschicht ist zum Beispiel in einer Ecke der Strahlungsauskoppelfläche angeordnet. Die erste Kontaktschicht bedeckt dabei nur einen kleinen Anteil der Strahlungsauskoppelfläche und dient zum elektrischen Kontaktieren des Leuchtdiodenchips. Bevorzugt enthält die Kontaktschicht ein Metall. Aufgrund der seitlichen Anordnung der Kontaktschicht ergibt sich vorteilhaft, dass der überwiegend größte Teil der Strahlungsfläche von der Kontaktschicht unbedeckt ist und damit die im Leuchtdiodenchip erzeugte elektromagnetische Strahlung ungehindert durch die Strahlungsauskoppelfläche ausgekoppelt werden kann. Bevorzugt bildet die Kontaktschicht dabei die Kathode des Leuchtdiodenchips.
Besonders bevorzugt bildet die Kontaktschicht ein Bondpad für das Kontaktieren des Leuchtdiodenchips mittels beispielweise "Wire Bonding". Das bedeutet, über die Kontaktschicht ist der Leuchtdiodenchip bevorzugt mittels eines Anschlussdrahts elektrisch kontaktiert. Sowohl Kontaktschicht als auch Anschlussdraht sind dabei bevorzugt vom Gehäuse umhüllt. Dies erhöht auch vorteilhaft die mechanische Stabilität der Verbindung zwischen Bondpad und Anschlussdraht. Das heißt, auch die Kontaktschicht ist zumindest stellenweise vom Gehäusematerial bedeckt.

In einer weiteren bevorzugten Ausführungsform der Leuchtdiodenanordnung ist die strahlungserzeugende Schicht des Leuchtdiodenchips zwischen einer reflektierenden Schicht und der Strahlungsauskoppelfläche angeordnet. Diese reflektierende Schicht erweist sich sowohl für die Abstrahlintensität des Leuchtdiodenchips, als auch für die Konversion des abgestrahlten Lichts als besonders vorteilhaft. So wird in der strahlungserzeugenden Schicht erzeugte Strahlung, die beispielsweise von einem Partikel des Lumineszenzkonversionsmaterials zurück in den Leuchtdiodenchip reflektiert wird, erneut von der Spiegelfläche der reflektierenden Schicht zurück reflektiert und kann dadurch wiederum durch die Strahlungsauskoppelfläche ausgekoppelt werden. Die Lichtausbeute einer solchen Leuchtdiodenanordnung ist daher besonders groß.

Die strahlungserzeugende Schicht ist besonders bevorzugt als Epitaxie-Schichtfolge ausgestaltet und enthält beispielsweise eine Multi-Quantentopfstruktur zur Erzeugung der elektromagnetischen Strahlung.

In einer besonders bevorzugen Ausführungsform der Leuchtdiodenanordnung ist der Leuchtdiodenchip ein Dünnfilm-Leuchtdiodenchip. Solch ein Dünnfilm-Leuchtdiodenchip zeichnet sich insbesondere durch die folgenden Merkmale aus:
- An einer zu einem Trägerelement hingewandten ersten Hauptfläche der strahlungserzeugenden Epitaxie-Schichtfolge des Leuchtdiodenchips ist eine reflektierende Schicht aufgebracht oder ausgebildet, die zumindest einen Teil der in der strahlungserzeugenden Schicht erzeugten elektromagnetischen Strahlung zurück reflektiert.
- Die strahlungserzeugende Schicht weist eine Dicke im Bereich von 20 *µ*m und weniger auf, insbesondere im Bereich von 10 *µ*m.
- Die strahlungserzeugende Schicht enthält mindestens eine Halbleiterschicht mit zumindest einer Fläche, die eine Durchmischungsstruktur aufweist, die im Idealfall zu einer annähernd ergodischen Verteilung des Lichts in der strahlungserzeugenden Schicht führt, d. h. sie weist ein möglichst ergodisches Streuverhalten auf.
Ein Grundprinzip eines Dünnschicht-Leuchtdiodenchips ist beispielsweise in I. Schnitzer et al., Appl. Phys. Lett. 63 (16, 18), Oktober 1993, 2174-2176 beschrieben, deren Offenbarungsgehalt insofern hiermit durch Rückbezug aufgenommen wird. Ein Dünnfilm-Leuchtdiodenchip ist in guter Näherung ein Lambert'scher Oberflächenstrahler und eignet sich von daher besonders gut für die Anwendung in einem Scheinwerfer.
Das Gehäuse, in das der Leuchtdiodenchip eingebettet ist, ist strahlungsabsorbierend ausgestaltet. Strahlungsabsorbierend heißt dabei zum Beispiel, dass das Gehäuse für die vom Leuchtdiodenchip emittierte elektromagnetische Strahlung oder auch das Umgebungslicht absorbierend ausgebildet ist. Bevorzugt enthält das Gehäuse dabei schwarzes Mold Compound. Das Mold Compound kann dabei beispielsweise rußgeschwärzt sein. Durch die Schwärzung des Mold Compounds ergibt sich vorteilhaft ein guter Kontrast zwischen Lichtaustrittsfläche der Leuchtdiodenanordnung und dem umgebenden Gehäuse. Die strahlungsabsorbierende Ausgestaltung des Gehäuses erweist sich als besonders vorteilhaft, da sie einen definierten Lichtaustritt ermöglicht. Die im Leuchtdiodenchip erzeugte elektromagnetische Strahlung kann also die Leuchtdioden-Anordnung im Wesentlichen nur an den dafür vorgesehenen Stellen, das heißt durch die Strahlungsauskoppelfläche und damit durch die Leuchtstoffschicht hindurch verlassen. Da damit annähernd die komplette, im Leuchtdiodenchip erzeugte Strahlung die Anordnung durch die Leuchtstoffschicht hindurch verlässt, trägt das strahlungsabsorbierende Gehäuse zudem zu einer besonders effektiven Konvertierung der ausgesandten Strahlung bei.

In einer weiteren bevorzugten Ausführungsform ist auf die Leuchtstoffschicht ein Abdeckkörper aufgebracht. Der Abdeckkörper ist zweckmäßig im Wesentlichen aus einem Material gebildet, dessen thermischer Ausdehnungskoeffizient dem thermischen Ausdehnungskoeffizienten der Leuchtstoffschicht entspricht oder sehr ähnlich ist. Bevorzugt ist der Abdeckkörper im gleichen Materialsystem wie die Matrix der Leuchtstoffschicht gestaltet. Dadurch ergibt sich vorteilhaft ein Vermindern der mechanischen Belastung der Leuchtdiodenanordnung beim Betrieb des Leuchtdiodenchips.

Besonders bevorzugt ist der Abdeckkörper als optisches Element ausgebildet. Das optische Element bietet vorteilhaft die Möglichkeit, die Abstrahlcharakteristik der Leuchtdiodenanordnung je nach Anwendungsgebiet der Leuchtdiodenanordnung anzupassen. Insbesondere kann das optische Element dabei als refraktive oder diffraktive Optik gestaltet sein.

In einer besonders bevorzugten Ausführungsform der Leuchtdiodenanordnung ist der Leuchtdiodenchip auf einem Träger angeordnet. Der Leuchtdiodenchip ist bevorzugt auf den Träger gebondet. Der Träger dient vorzugsweise sowohl zur mechanischen Befestigung als auch zur elektrischen Kontaktierung des Leuchtdiodenchips. Dazu ist der Träger bevorzugt in geeigneter Weise strukturiert. Das heißt der Träger weist beispielsweise elektrische Leitungen und Anschlussstellen zum Kontaktieren des Chips auf.

In einer besonders bevorzugten Ausführungsform der Leuchtdiodenanordnung weist die Leuchtdiodenanordnung eine Vielzahl von Leuchtdiodenchips auf. Die Anordnung der Leuchtdiodenchips zueinander ist bevorzugt an die Einsatzerfordernisse der Leuchtdiodenanordnung angepasst. So ist es beispielsweise möglich, die geometrische Anordnung der Leuchtdiodenchips an den Einsatzort der Leuchtdiodenanordnung anzupassen. Auch ist es möglich die Form des Träger und des Gehäuses in geeigneter Weise an solche Einsatzerfordernisse anzupassen.

Insgesamt macht sich die Leuchtdiodenanordnung unter anderem die Idee zunutze, dass die Kombination von einem Leuchtdiodenchip mit einer hochreflektierenden Spiegelschicht und einer dünnen Leuchtstoffschicht auf der Strahlungsauskoppelfläche eine sehr effiziente Konversion der emittierten Strahlung ermöglicht, da der überwiegende Anteil der im Leuchtdiodenchip erzeugten elektromagnetischen Strahlung durch die Konversionsschicht hindurch ausgekoppelt wird. Es ergibt sich vorteilhaft, dass das definierte Ummolden der Leuchtdiodenchips mit einem strahlungsabsorbierenden Mold Compound als Gehäuse besonders gute Kontrastwerte und eine definierte Lichtauskopplung der elektromagnetischen Strahlung durch die Strahlungsauskoppelfläche und damit die Leuchtstoffschicht ermöglicht.

Es wird darüber hinaus ein Verfahren zur Herstellung einer Leuchtdiodenanordnung nach Anspruch 11 angegeben, das die folgenden Schritte umfasst.
a) Bereitstellen eines Trägers,
b) Befestigen eines Leuchtdiodenchips, aufweisend eine Strahlungsauskoppelfläche auf eine Oberfläche des Trägers,
c) Einbetten des Leuchtdiodenchips in ein Gehäuse,
d) Aufbringen einer Leuchtstoffschicht auf die Strahlungsauskoppelfläche des Leuchtdiodenchips.
Hierbei ist insbesondere zu beachten, dass die Verfahrensschritte grundsätzlich in beliebiger Reihenfolge ausgeführt werden können, die hier durch die alphabetisch angeordneten Buchstaben angegebene Reihenfolge muss nicht zwingend eingehalten werden.
In einer besonders bevorzugten Ausführungsform des Verfahrens wird in Schritt b) des Verfahrens der Leuchtdiodenchip sowohl mechanisch auf dem Träger befestigt, als auch elektrisch kontaktiert.
In Schritt d) des beschriebenen Verfahrens bleiben bevorzugt zumindest Teile der Strahlungsauskoppelfläche unbedeckt. Dies kann beispielsweise dadurch realisiert werden, dass Teile der Strahlungsauskoppelfläche beim Einbetten des Leuchtdiodenchips in die Gehäuseumhüllung durch eine Maske bedeckt werden.
In einer weiteren bevorzugten Ausführungsform des Verfahrens wird nach Beendigung des beschriebenen Verfahrens ein Abdeckkörper auf die Leuchtstoffschicht aufgebracht. Vorteilhaft bedeckt der Abdeckkörper die Leuchtstoffschicht dabei vollständig. Beispielsweise ist der Abdeckkörper vor dem Aufbringen auf die Leuchtstoffschicht bereits vorgefertigt. Er kann dann auf die Leuchtstoffschicht geklebt werden. Es ist aber auch möglich, dass das Abdeckkörpermaterial auf die Leuchtstoffschicht aufgespritzt wird, in die gewünschte Form gebracht und anschließend ausgehärtet wird. Das Gehäuse, in das der Leuchtdiodenchip eingebettet ist, ist strahlungsabsorbierend ausgestaltet. Das bedeutet, die Gehäusemasse ist geeignet, zumindest einen Großteil der im Leuchtdiodenchip erzeugten elektromagnetischen Strahlung, die auf das Gehäuse trifft, zu absorbieren.
In einer besonders bevorzugten Ausführungsform des Verfahrens wird eine Vielzahl von Leuchtdiodenchips auf dem Träger befestigt. Die Form des Trägers, wie auch die Anordnung der Leuchtdiodenchips auf dem Träger, lässt sich den Einsatzerfordernissen der Anordnung vorteilhaft anpassen.
Im Folgenden wird die hier beschriebene Leuchtdiodenanordnung als auch ein Verfahren zur Herstellung einer solchen Leuchtdiodenanordnung anhand von Ausführungsbeispielen und den dazugehörigen Figuren näher erläutert:
Figur 1 zeigt eine Prinzipskizze einer hier beschriebenen Leuchtdiodenanordnung.
Figur 2 zeigt einen Leuchtdiodenchip, wie er in der beschriebenen Anordnung Verwendung finden kann.
Figur 3 zeigt in den Figuren 3a bis 3g ein Ausführungsbeispiel eines hier beschriebenen Verfahrens.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

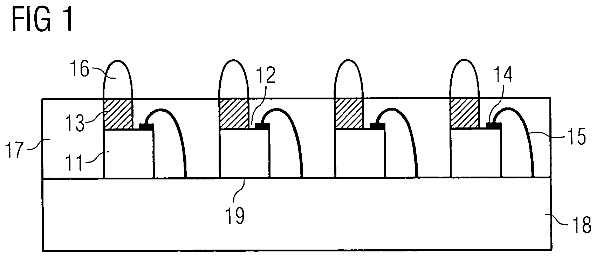

Figur 1 zeigt eine hier beschriebene Leuchtdiodenanordnung, enthaltend Leuchtdiodenchips 11. Die Leuchtdiodenchips 11 weisen an ihrer Oberseite eine Strahlungsauskoppelfläche 12 auf. Auf einen Teil der Strahlungsauskoppelfläche 12 ist eine Leuchtstoffschicht 13 aufgebracht.

Die Leuchtstoffschicht 13 enthält vorteilhaft ein Lumineszenzkonversionsmaterial-Matrix-Gemisch. Die Matrix ist dabei beispielsweise aus duroplastischen Polymeren wie Epoxymaterialien oder Silikonmaterialien gebildet. Der Gehalt an Lumineszenzkonversionsmaterial ist vorteilhaft hoch. Besonders bevorzugt sind der Matrix zwischen 30 und 50 Vol% Leuchtstoffmaterial beigemischt. Lumineszenzkonversionsmaterialien können dotierte Granate wie YAG oder TAG, Chlorosilikate, Erdalkali-Nitridosilikate oder Erdalkali-Oxinitridosilikate sein. Geeignete Lumineszenz-Konversionsmaterialien sind beispielsweise in der Druckschrift WO98/12757 beschrieben, deren Inhalt insofern hiermit durch Rückbezug aufgenommen wird.

Die Leuchtstoffschicht 13 ist vorteilhaft in einer relativ dünnen Schicht von zwischen 10 und 50 *µ*m Dicke auf die Strahlungsauskoppelfläche 12 aufgerakelt oder durch spezielle Drucktechniken wie Siebdruck oder Tampondruck aufgedruckt. Alternativ ist es jedoch auch möglich, dass das Lumineszenzkonversionsmaterial mittels einer Dispenstechnik, wie beispielsweise eines Inkjet-Verfahrens, oder mittels eines Piezo-Ventil-Dispensers auf die Strahlungsauskoppelfläche 12 aufgebracht ist.

Ein zweiter Teil der Strahlungsauskoppelfläche ist von einer ersten Kontaktschicht 14 bedeckt, die ein Bondpad bildet. Über diese erste Kontaktschicht 14 ist der Leuchtdiodenchip 11 mittels eines Anschlussdrahts 15 beispielsweise durch Wire Bonding elektrisch kontaktiert. Die erste Kontaktschicht 14 enthält dabei vorteilhaft Aluminium und bildet den n-seitigen Anschluss des Leuchtdiodenchips.

Auf die Leuchtstoffschicht 13 ist ein Abdeckkörper 16 aufgebracht. Der Abdeckkörper 16 bildet dabei bevorzugt ein optisches Element, das die Möglichkeit bietet, die Abstrahlcharakteristik der Leuchtdiodenanordnung je nach den Erfordernissen der Leuchtdiodenanordnung einzustellen. Es können dabei sowohl refraktive als auch diffraktive optische Elemente Verwendung finden. Die Seitenflächen des Abdeckkörpers 16 sind dazu bevorzugt im Wesentlichen parabolisch, hyperbolisch oder elliptisch gekrümmt.

Da die Emissionsfläche der Leuchtstoffschicht 13 der Chipemissionsfläche, d. h. der Strahlungsauskoppelfläche 12, bei der beschriebenen Leuchtdiodenanordnung sehr ähnlich ist, eignet sich die Leuchtdiodenanordnung besonders gut für solche zusätzlichen optischen Elemente. Denn nahezu das gesamte von den Leuchtdiodenchips 11 emittierte Licht, wird in der Leuchtstoffschicht konvertiert und kann dann durch den Abdeckkörper 16 aus der Anordnung austreten.

Dabei ist der Abdeckkörper 16 vorteilhaft im gleichen Materialsystem wie die Matrix der Leuchtstoffschicht 13 gestaltet.

Dies erweist sich beim Betrieb der Leuchtdiodenchips 11 als besonders vorteilhaft, da Abdeckkörper 16 und Leuchtstoffschicht 13 dann einen annähernd gleichen thermischen Ausdehnungskoeffizienten aufweisen und die Verbindung zwischen Leuchtstoffschicht 13 und Abdeckkörper 16 durch die von den Leuchtdiodenchips 11 abgegebene Wärme kaum mechanisch belastet wird.
Die Leuchtdiodenchips 11 sind in ein Gehäuse 17 eingebettet, sodass die Seitenfläche der Leuchtdiodenchips 11 sowie Teile der Strahlungsauskoppelfläche 12 durch das Gehäuse 17 formschlüssig umhüllt werden. Vorteilhafterweise sind auch die Anschlussdrähte 15 von der Gehäusemasse umhüllt. Dies erhöht die mechanische Stabilität der Verbindung von Anschlussdraht 15 und erster Kontaktschicht 14. Auch die Seitenflächen der Leuchtstoffschicht 13 sind formschlüssig vom Gehäuse 17 umhüllt. Da das Gehäuse 17 strahlungsabsorbierend, beispielsweise schwarz, ausgestaltet ist, besitzt die Leuchtdiodenanordnung mit der Oberfläche der Leuchtstoffschicht 13, die der Strahlungsauskoppelfläche 12 gegenüberliegt, eine definierte Lichtaustrittsfläche mit gutem Kontrast zum umgebenden Gehäuse 17. Das Gehäuse 17 enthält dabei bevorzugt ein Mold Compound, wie duroplastische Polymere (Epoxymaterialien oder Silikonmaterialien). Bevorzugt ist das Mold Compound strahlungsabsorbierend ausgebildet. Das heißt, ein Großteil der vom Leuchtdiodenchip emittierten elektromagnetischen Strahlung, die auf das Mold Compound trifft, wird von diesem absorbiert. Der Strahlungsaustritt ist auf diese Weise gezielt auf Bereiche der Strahlungsaustrittsfläche 12 eingeschränkt, die von der Leuchtstoffschicht 13 bedeckt sind. Beispielsweise ist das Mold Compound mittels Ruß geschwärzt. Das Mold Compound kann dabei so gewählt werden, dass sein thermischer Ausdehnungskoeffizient den restlichen Bestandteilen der Leuchtdiodenanordnung gut angepasst ist und damit eine hohe mechanische Stabilität der Anordnung gegeben ist.

Leuchtdiodenchips 11 und Gehäuse 17 sind vorteilhaft auf einen Träger 18 aufgebracht. Der Träger 18 kann beispielsweise ein Printed Circuit Board (PCB), eine Keramik, ein Direct Bonded Copper Substrate (DBC), eine Metallkernplatine sein oder allgemein aus strukturierbaren Materialien wie beispielsweise Silizium gebildet sein.

Die Leuchtdiodenchips sind mittels ihrer zweiten Kontaktschicht 19 auf dem Träger sowohl mechanisch befestigt als auch elektrisch kontaktiert, beispielsweise durch einen Die Bonding Prozess. Die zweite Kontaktschicht 19 bildet vorzugsweise den p-seitigen Anschluss des Leuchtdiodenchips 11. Auch der Anschlussdraht 15 ist zur n-seitigen Kontaktierung der Leuchtdiodenchips 11 mit dem Träger 18 verbunden.

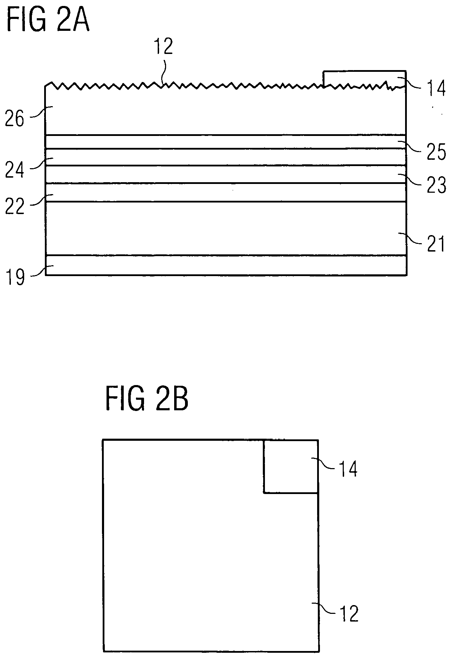

Figur 2A zeigt eine Schnittdarstellung eines Leuchtdiodenchips 11, wie er in der Leuchtdiodenanordnung Verwendung finden kann. Geeignete Leuchtdiodenchips sind dabei beispielsweise oberflächenemittierende Halbleiterchips nach dem Dünnfilmkonzept, die unterhalb der strahlungserzeugenden Schicht 25 eine hoch reflektierende Schicht 23 beinhalten. An der Unterseite des Leuchtdiodenchips befindet sich die p-seitige zweite Kontaktschicht 19. Die zweite Kontaktschicht 19 ist auf ein Trägerelement 21 aufgebracht.

Dem Trägerelement 21 folgt die reflektierende Schicht 23 nach, die mittels einer Lötschicht 22 auf dem Trägerelement 21 befestigt ist. Die reflektierende Schicht 23 bildet dabei eine Spiegelschicht und ist bevorzugt aus einem Metall gebildet. Dabei kann die reflektierende Schicht 23 beispielsweise Silber enthalten.

Der Spiegelschicht folgt eine Pufferschicht 24 nach, die beispielsweise p-dotiertes GaN enthält und für die von der in der strahlungserzeugenden Schicht 25 erzeugte Strahlung durchlässig ist. Die strahlungserzeugende Schicht 25 umfasst vorteilhaft mehrere epitaktisch gewachsene Schichten. Sie basiert beispielsweise auf einem Nitrid-Verbindungs-Halbleitermaterial, d. h. mindestens eine Schicht der epitaktisch gewachsenen Schichtfolge weist ein Material aus dem System InₓAl_{y}Ga_{1-x-y}N, mit 0 ≤ x ≤ 1, 0 ≤ y ≤ 1 und x + y ≤ 1 auf. Zudem kann die strahlungserzeugende Schicht 25 eine Multi-Quantentopfstruktur aufweisen. Anstelle der Multi-Quantentopfstruktur kann auch eine Einfach-Quantentopfstruktur, eine Doppel-Heterostruktur oder eine Einfach-Heterostruktur Verwendung finden. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Auf die strahlungserzeugende Schicht 25 folgt die Deckschicht 26, die vorzugsweise n-dotiertes GaN enthält. Die Deckschicht 26 ist vorzugsweise für die in der strahlungserzeugenden Schicht 25 erzeugte elektromagnetische Strahlung durchlässig. Sie weist an ihrer Oberfläche die Strahlungsauskoppelfläche 12 auf, die vorteilhaft zum Beispiel in zufälliger Weise strukturiert ist.

Durch diese Strukturierung der Strahlungsauskoppelfläche 12 ist erreicht, dass eine Totalreflexion der vom Leuchtdiodenchip emittierten Strahlung seltener stattfindet, als dies bei einer glatten Strahlungsauskoppelfläche 12 der Fall wäre. Außerdem kann eine geeignete Strukturierung der Strahlungsauskoppelfläche 12 zu einem annähernd ergodisch stochastischem Streuverhalten des Leuchtdiodenchips führen.

Seitlich auf die Strahlungsauskoppelfläche 12 ist die erste Kontaktschicht 14 aufgebracht. Figur 2B zeigt dabei eine Draufsicht auf den Leuchtdiodenchip mit der Strahlungsauskoppelfläche 12 und der in einem seitlichen Eck aufgebrachten ersten Kontaktschicht 14. Aufgrund dieser seitlichen Anordnung der ersten Kontaktschicht 14 nimmt die erste Kontaktschicht 14 nur wenig Fläche auf der Strahlungsauskoppelfläche 12 ein und behindert damit den Austritt der elektromagnetischen Strahlung durch die Strahlungsauskoppelfläche 12 kaum.

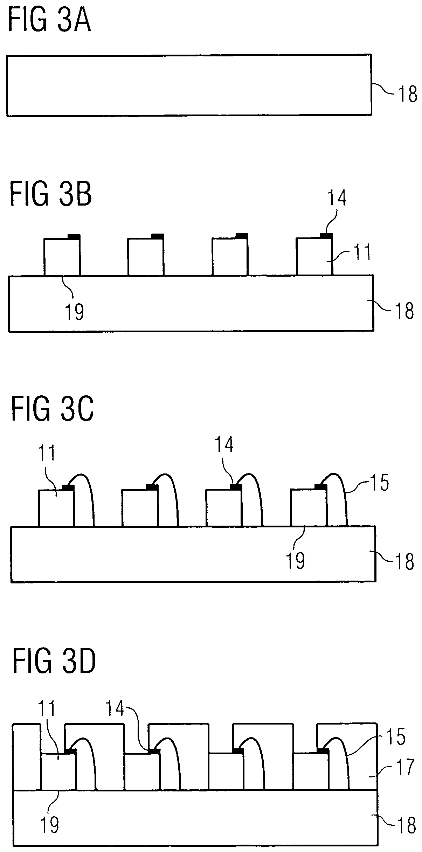

Die Figuren 3A bis 3G zeigen ein Ausführungsbeispiel eines beschriebenen Verfahrens zur Herstellung der Leuchtdiodenanordnung.

Figur 3A zeigt eine Schnittdarstellung des Trägers 18.

Auf dem Träger 18 werden in einem ersten Verfahrensschritt die Leuchtdiodenchips 11 mittels Die-Bonding mechanisch befestigt und über die zweite Kontaktschicht 19 elektrisch mit dem Träger 18 kontaktiert (siehe Figur 3B).

Figur 3C zeigt die elektrische Kontaktierung der Leuchtdiodenchips mittels Anschlussdrähten 15 mit dem Träger 18. Die Kontaktierung findet dabei über einen Wire-Bonding Prozess statt, bei dem der Anschlussdraht 15 auf dem Träger 18 und der ersten Kontaktschicht 14, die ein Bondpad bildet, befestigt wird.

Im folgenden Verfahrensschritt werden die Leuchtdiodenchips in ein Gehäuse 17 eingebettet (siehe Figur 3D). Dazu werden die Leuchtdiodenchips beispielsweise mit einem schwarzen Mold Compound mittels eines Spritzgussverfahrens oder anderer geeigneter Verfahren wie beispielsweise Druckprozesse formschlüssig umhüllt. Um den Teil der Strahlungsauskoppelfläche dabei vom Mold Compound freizuhalten, auf dem anschließend die Leuchtstoffschicht 13 aufgebracht werden soll, kann eine Maske verwendet werden, die diese Stellen der Strahlungsauskoppelfläche 12 freihält. Alternativ können die Teile der Strahlungsauskoppelfläche 12, auf die die Leuchtstoffschicht 13 aufgebracht werden soll, nach dem Molden durch Ätzen wieder freigelegt werden. Weiterhin ist es möglich, dass die Leuchtstoffschicht 13 schon vor dem Ummolden auf die Strahlungsauskoppelfläche 12 der Leuchtdiodenchips aufgebracht wird. Insbesondere kann die Leuchtstoffschicht 13 dabei noch im Waferverbund auf die Strahlungsauskoppelfläche 12 aufgebracht werden.

Beim Ummolden der Leuchtdiodenchips 11 wird außerdem vorteilhaft die Oberfläche des Trägers, die nicht durch Leuchtdiodenchips bedeckt ist, mit Moldmasse formschlüssig umhüllt. Außerdem werden bevorzugt auch die ersten Kontaktschichten 14 und die Anschlussdrähte 15 von der Moldmasse umhüllt. Dadurch ergibt sich eine mechanische Stabilisierung der Leuchtdiodenanordnung. Vorteilhaft können der Moldmasse Füllstoffe beigemengt sein (zum Beispiel Adhäsionsvermittler oder CTE), die eine gute Anpassung des Gehäuses an den Träger ermöglichen. Beispielsweise ist dadurch der thermische Ausdehnungskoeffizient des Gehäuses dem des Trägers angepasst. Diese Maßnahme erhöht vorteilhaft die mechanische Stabilität der Anordnung.

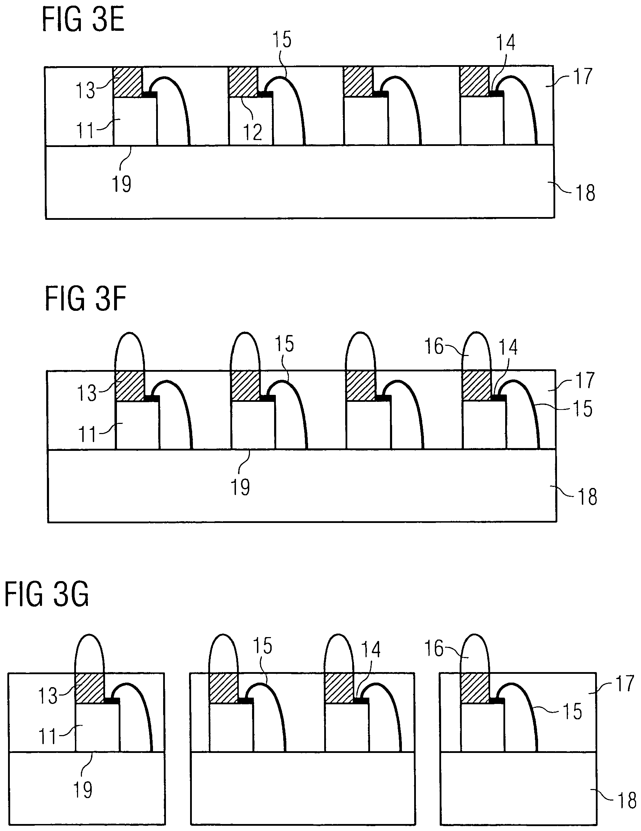

Figur 3E zeigt das Aufbringen der Leuchtstoffschicht 13 auf die Strahlungsauskoppelfläche 12. Vorteilhaft sind auch die Seitenflächen der Leuchtstoffschicht 13 von der Gehäusemasse umhüllt, sodass in der strahlungserzeugenden Schicht 25 erzeugte elektromagnetische Strahlung größtenteils durch die der Strahlungsauskoppelfläche 12 gegenüberliegende Oberfläche der Leuchtstoffschicht 13 austritt.

Figur 3F zeigt das Aufbringen der Abdeckkörper 16 auf die Leuchtstoffschicht 13. Bei den Abdeckkörpern 16 kann es sich beispielsweise um vorgefertigte optische Elemente handeln, die auf die Leuchtstoffschicht 13 aufgeklebt werden. Es ist aber beispielsweise auch möglich, dass die Abdeckkörper 16 auf die noch nicht ausgehärtete Leuchtstoffschicht 13 gedrückt werden und beim Aushärten der Leuchtstoffschicht 13 eine feste mechanische Verbindung mit dieser eingehen.

Alternativ können die Abdeckkörper 16 auch auf die Leuchtstoffschicht 13 gespritzt werden. Dabei können thixotrope Materialien Verwendung finden, die auf die Leuchtstoffschicht 13 gespritzt und nachfolgend in die gewünschte Form gebracht werden. Bevorzugt enthält der Abdeckkörper dabei Silikon. Auch ist es möglich, Materialien mit einer hohen Oberflächenspannung als Tropfen auf die Leuchtstoffschicht 13 aufzubringen und sie anschließend gegebenenfalls unter Verwendung von ultravioletter Strahlung auszuhärten.

In einem weiteren Verfahrensschritt (siehe Figur 3G) ist es möglich, die Leuchtdiodenanordnung derart zu vereinzeln, dass Leuchtdiodenanordnungen entstehen, die die gewünschte Form und Anzahl von Leuchtdiodenchips 11 aufweisen. Alternativ ist es natürlich möglich, die Leuchtdiodenanordnung von Anfang an in der gewünschten Form mit der gewünschten Anzahl und Anordnung von Leuchtdiodenchips 11 zu fertigen.

## Patentansprüche

1. Leuchtdioden-Anordnung, aufweisend
- wenigstens einen Leuchtdiodenchip (11) mit einer Strahlungsauskoppelfläche (12), über die ein Großteil der im Leuchtdiodenchip (11) erzeugten elektromagnetischen Strahlung ausgekoppelt wird,
- wenigstens eine Leuchtstoffschicht (13), die auf die Strahlungsauskoppelfläche (12) angeordnet ist,
- ein Gehäuse (17), in das der Leuchtdiodenchip (11) eingebettet ist, wobei
- der zumindest eine Leuchtdiodenchip (11) formschlüssig vom Gehäuse (17) umhüllt ist und die Oberfläche der Leuchtstoffschicht (13), die der Strahlungsauskoppelfläche (12) des Leuchtdiodenchips gegenüberliegt, vom Gehäuse (17) zumindest teilweise unbedeckt ist,
**dadurch gekennzeichnet, dass**
- die Seitenflächen sowie Teile der Strahlungsauskoppelfläche (12) des Leuchtdiodenchips (11) durch das Gehäuse (17) formschlüssig umhüllt sind und das Gehäuse (17) strahlungsabsorbierend ausgebildet ist.

2. Leuchtdioden-Anordnung nach dem vorherigen Anspruch,
bei der an einem Rand der Strahlungsauskoppelfläche (12) eine erste Kontaktschicht (14) zur elektrischen Kontaktierung des Leuchtdiodenchips (11) angeordnet ist.

3. Leuchtdioden-Anordnung nach einem der vorherigen Ansprüche,
bei der eine strahlungserzeugende Schicht (25) des Leuchtdiodenchips (11) zwischen einer reflektierenden Schicht (23) und der Strahlungsauskoppelfläche (12) angeordnet ist.

4. Leuchtdioden-Anordnung nach einem der Ansprüche 1 bis 3,
bei der die Leuchtstoffschicht (13) zwischen 10 und 50 µm dick ist.

5. Leuchtdioden-Anordnung nach einem der Ansprüche 1 bis 4,
bei der die Kontaktschicht (14) zumindest stellenweise vom Gehäuse (17) bedeckt ist.

6. Leuchtdioden-Anordnung nach einem der Ansprüche 1 bis 5,
bei der ein Anschlussdraht (15) vom Gehäuse (17) umhüllt ist.

7. Leuchtdioden-Anordnung nach einem der Ansprüche 1 bis 6,
bei der auf der Leuchtstoffschicht (13) ein Abdeckkörper (16) angeordnet ist.

8. Leuchtdioden-Anordnung nach Anspruch 7,
bei der der Abdeckkörper (16) ein optisches Element ist.

9. Leuchtdioden-Anordnung nach einem der Ansprüche 1 bis 8,
bei der der Leuchtdiodenchip (11) auf einem Träger (18) angeordnet ist.

10. Leuchtdioden-Anordnung nach einem der Ansprüche 1 bis 9, aufweisend eine Vielzahl von Leuchtdiodenchips (11).

11. Verfahren zur Herstellung einer Leuchtdioden-Anordnung, aufweisend folgende Schritte:
a) Bereitstellen eines Trägers (18),
b) Befestigen eines Leuchtdiodenchips (11), aufweisend eine Strahlungsauskoppelfläche (12) auf dem Träger (18),
c) Einbetten des Leuchtdiodenchips (11) in ein Gehäuse (17),
d) Aufbringen einer Leuchtstoffschicht (13) auf die Strahlungsauskoppelfläche (12) des Leuchtdiodenchips (11), wobei
- der zumindest eine Leuchtdiodenchip (11) formschlüssig vom Gehäuse (17) umhüllt ist und die Oberfläche der Leuchtstoffschicht (13), die der Strahlungsauskoppelfläche (12) des Leuchtdiodenchips gegenüberliegt, vom Gehäuse (17) zumindest teilweise unbedeckt ist,
**dadurch gekennzeichnet, dass**
- die Seitenflächen sowie Teile der Strahlungsauskoppelfläche (12) des Leuchtdiodenchips (11) durch das Gehäuse (17) formschlüssig umhüllt sind und das Gehäuse (17) strahlungsabsorbierend ausgebildet ist.

12. Verfahren zur Herstellung einer Leuchtdioden-Anordnung nach Anspruch 11,
wobei ein Abdeckkörper (16) auf die Leuchtstoffschicht (13) aufgebracht wird.

13. Verfahren zur Herstellung einer Leuchtdioden-Anordnung nach einem der Ansprüche 11 oder 12,
wobei eine Vielzahl von Leuchtdiodenchips (11) auf dem Träger (18) befestigt wird.

## Claims

1. Light-emitting diode arrangement, comprising
- at least one light-emitting diode chip (11) having a radiation decoupling area (12) via which a majority of the electromagnetic radiation generated in the light-emitting diode chip (11) is decoupled,
- at least one phosphor layer (13) arranged on the radiation decoupling surface (12),
- a housing (17) in which the light-emitting diode chip (11) is embedded, wherein
- the at least one light-emitting diode chip (11) is enclosed in a form-fitting manner by the housing (17), and the surface of the phosphor layer (13) which lies opposite the radiation decoupling area (12) of the light-emitting diode chip is at least partially uncovered by the housing (17), **characterized in that**
- the side surfaces and parts of the radiation decoupling surface (12) of the light-emitting diode chip (11) are enclosed in a form-fitting manner by the housing (17) and the housing (17) is formed to be radiation-absorbing.

2. Light-emitting diode arrangement according to the preceding claim,
in which a first contact layer (14) for electrically contacting of the light-emitting diode chip (11) is arranged on one edge of the radiation decoupling surface (12).

3. Light-emitting diode arrangement according to one of the preceding claims,
in which a radiation-generating layer (25) of the light-emitting diode chip (11) is arranged between a reflective layer (23) and the radiation decoupling surface (12).

4. Light-emitting diode arrangement according to one of claims 1 to 3,
in which the phosphor layer (13) is between 10 and 50 µm thick.

5. Light-emitting diode arrangement according to one of claims 1 to 4,
in which the contact layer (14) is covered at least in places by the housing (17).

6. Light-emitting diode arrangement according to one of claims 1 to 5,
in which a connection wire (15) is covered by the housing (17) .

7. Light-emitting diode arrangement according to one of claims 1 to 6,
in which a covering body (16) is arranged on the phosphor layer (13).

8. Light-emitting diode arrangement according to claim 7,
in which the covering body (16) is an optical element.

9. Light-emitting diode arrangement according to one of claims 1 to 8,
in which the light-emitting diode chip (11) is disposed on a carrier (18).

10. Light-emitting diode arrangement according to one of claims 1 to 9,
comprising a multiplicity of light-emitting diode chips (11).

11. Method of producing a light-emitting diode arrangement comprising the following steps,
a) providing a carrier (18),
b) attaching an light-emitting diode chip (11) comprising a radiation decoupling surface (12) on the carrier (18),
c) embedding the light-emitting diode chip (11) in a housing (17),
d) applying a phosphor layer (13) to the radiation decoupling surface (12) of the light-emitting diode chip (11), wherein
- the at least one light-emitting diode chip (11) is enclosed in a form-fitting manner by the housing, and the surface of the phosphor layer (13) which lies opposite the radiation decoupling area (12) of the light-emitting diode chip is at least partially uncovered by the housing (17), **characterized in that**
- the side surfaces and parts of the radiation decoupling surface (12) of the light-emitting diode chip (11) are enclosed in a form-fitting manner by the housing (17) and the housing (17) is formed to be radiation-absorbing.

12. Method for producing a light-emitting diode arrangement according to claim 11,
wherein a covering body (16) is applied to the phosphor layer (13) .

13. Method for producing a light-emitting diode arrangement according to one of claims 11 or 12,
wherein a multiplicity of light-emitting diode chips (11) is attached to the carrier (18).

## Revendications

1. Agencement de diodes électroluminescentes, présentant
- au moins une puce à diode électroluminescente (11) avec d'une surface de sortie de rayonnement (12) par l'intermédiaire de laquelle une grande partie du rayonnement électromagnétique généré dans la puce à diode électroluminescente (11) est sortie,
- au moins une couche à substance luminescente (13) qui est disposée sur la surface de sortie de rayonnement (12),
- un boîtier (17) dans lequel est incorporée la puce à diode électroluminescente (11),
- l'au moins une puce à diode électroluminescente (11) étant enveloppée par le boîtier (17) avec adhérence de forme, et
- la surface de la couche à substance luminescente (13), qui est opposée à la surface de sortie de rayonnement (12) de la puce à diode électroluminescente, étant non recouverte par le boîtier (17) au moins en partie,
**caractérisé en ce que**
- les surfaces latérales ainsi que des parties de la surface de sortie de rayonnement (12) de la puce à diode électroluminescente (11) sont enveloppées par le boîtier (17) avec adhérence de forme et **en ce que** le boîtier (17) est réalisé de manière à absorber le rayonnement.

2. Agencement de diodes électroluminescentes selon la revendication précédente, dans lequel une première couche de contact (14) destinée à la mise en contact électrique de la puce à diode électroluminescente (11) est disposée sur un bord de la surface de sortie de rayonnement (12).

3. Agencement de diodes électroluminescentes selon l'une quelconque des revendications précédentes, dans lequel une couche (25), générant un rayonnement, de la puce à diode électroluminescente (11) est disposée entre une couche réfléchissante (23) et la surface de sortie de rayonnement (12).

4. Agencement de diodes électroluminescentes selon l'une quelconque des revendications 1 à 3, dans lequel la couche à substance luminescente (13) est d'une épaisseur comprise entre 10 et 50 µm.

5. Agencement de diodes électroluminescentes selon l'une quelconque des revendications 1 à 4, dans lequel la couche de contact (14) est recouverte au moins en partie par le boîtier (17).

6. Agencement de diodes électroluminescentes selon l'une quelconque des revendications 1 à 5, dans lequel un fil de connexion (15) est enveloppé par le boîtier (17).

7. Agencement de diodes électroluminescentes selon l'une quelconque des revendications 1 à 6, dans lequel un corps de recouvrement (16) est disposé sur la couche à substance luminescente (13).

8. Agencement de diodes électroluminescentes selon la revendication 7, dans lequel le corps de recouvrement (16) est un élément optique.

9. Agencement de diodes électroluminescentes selon l'une quelconque des revendications 1 à 8, dans lequel la puce à diode électroluminescente (11) est disposée sur un support (18).

10. Agencement de diodes électroluminescentes selon l'une quelconque des revendications 1 à 9, présentant une pluralité de puces à diode électroluminescente (11).

11. Procédé de fabrication d'un agencement de diodes électroluminescentes, présentant les étapes suivantes :
a) fourniture d'un support (18),
b) fixation sur le support (18) d'une puce à diode électroluminescente (11) présentant une surface de sortie de rayonnement (12),
c) incorporation de la puce à diode électroluminescente (11) dans un boîtier (17),
d) application d'une couche à substance luminescente (13) sur la surface de sortie de rayonnement (12) de la puce à diode électroluminescente (11),
- l'au moins une puce à diode électroluminescente (11) étant enveloppée par le boîtier (17) avec adhérence de forme, et
- la surface de la couche à substance luminescente (13), qui est opposée à la surface de sortie de rayonnement (12) de la puce à diode électroluminescente, étant non recouverte par le boîtier (17) au moins en partie,
**caractérisé en ce que**
- les surfaces latérales ainsi que des parties de la surface de sortie de rayonnement (12) de la puce à diode électroluminescente (11) sont enveloppées par le boîtier (17) avec adhérence de forme et **en ce que** le boîtier (17) est réalisé de manière à absorber un rayonnement.

12. Procédé de fabrication d'un agencement de diodes électroluminescentes selon la revendication 11,
un corps de recouvrement (16) étant appliqué sur la couche à substance luminescente (13).

13. Procédé de fabrication d'un agencement de diodes électroluminescentes selon l'une quelconque des revendications 11 ou 12,
une pluralité de puces à diode électroluminescente (11) étant fixée sur le support (18).
